Europäisches Patentamt

European Patent Office

Office européen des brevets

(11) Veröffentlichungsnummer: **0 477 881 A2**

# (12) EUROPÄISCHE PATENTANMELDUNG

(21) Anmeldenummer: **91116274.1**

(22) Anmeldetag: **24.09.91**

(51) Int. Cl.5: **H01G 1/147**, H01G 1/035

(30) Priorität: **28.09.90 DE 4030821**

(43) Veröffentlichungstag der Anmeldung:
**01.04.92 Patentblatt 92/14**

(84) Benannte Vertragsstaaten:
**AT BE CH DE ES FR GB GR IT LI LU NL SE**

(71) Anmelder: **SIEMENS AKTIENGESELLSCHAFT**
**Wittelsbacherplatz 2**
**W-8000 München 2(DE)**

(84) **BE CH DE ES FR GB GR IT LI LU NL SE**

(71) Anmelder: **SIEMENS MATSUSHITA**
**COMPONENTS OHG**
**Siemensstrasse 43**
**A-8530 Deutschlandsberg(AT)**

(84) **AT**

(72) Erfinder: **Zettl, Franz, Dr. Dipl.-Ing.**
**Papiermühlgasse 28**
**A-8020 Graz(AT)**
Erfinder: **Schuster, Hans Georg, Dr. Dipl.-Ing.**
**Dr. Robert-Graf-Strasse 42**
**A-8010 Graz(AT)**

(54) **Keramisches elektrisches Bauelement mit Anschlussmetallisierungen zur elektrischen Kontaktierung mittels Leitkleber.**

(57) Bei einem keramischen elektrischen Bauelement, insbesondere einem keramischen Vielschichtkondensator, mit Anschlußmetallisierungen zur elektrischen Kontaktierung mittels Leitkleber ist an den zur elektrischen Kontaktierung vorgesehenen Stellen des Bauelements jeweils als Anschlußmetallisierung eine weitgehend porenfreie Ni-Schicht galvanisch aufgetragen.

EP 0 477 881 A2

Die Erfindung betrifft ein keramisches elektrisches Bauelement, insbesondere einen keramischen Vielschichtkondensator, mit Anschlußmetallisierungen Zur elektrischen Kontaktierung mittels Leitkleber.

Seit einigen Jahren versucht die Industrie, die bisher weitgehend üblichen Lötverbindungen wenigstens in Teilbereichen durch leitfähige Klebstoffe zu ersetzten. Grund hierfür sind zunächst die beim Lötvorgang auftretenden, unerwünscht hohen Temperaturwerte von bis zu 250° C. Dieser Wärmeschwall kann sich auf die Bauelemente negativ auswirken, beispielsweise kann es bei einem PTC-Thermistor (Kaltleiter) auf der Basis von Bariumtitanat aufgrund von beim Löten auftretenden punktuellen Temperaturschocks zu einer sprunghaften Veränderung der kristallinen Gefügeordnung kommen. Ein ganz anderes Problem besteht darin, daß die Leiterplatten von dem für Lötvorgänge unentbehrlichen fetthaltigen Flußmitteln durch aggressive, umweltgefährende Stoffe gereinigt werden müssen. Aus diesen und anderen Gründen wurden deshalb Leitkleber entwickelt, die ohne chemische Lösemittel auskommen und die schon bei Temperaturen von ca. 120° C aushärten. Dabei handelt es sich heute zumeist um Epoxi-Silberleitkleber, bei dem Silberteilchen in Feinstflitterform in Kunstharze eingebettet sind, die infolge ihrer Moleküleigenschaften auf viele Materialien für eine außergewöhnlich gute Haftung sorgen.

Es hat sich jedoch herausgestellt, daß gerade bei den standardmäßig als Lötflächen für keramische Bauelemente verwendeten Einbrennmetallisierungen die üblichen Leitkleber nicht ohne weiteres eingesetzt werden können. Eine derartige Einbrennmetallisierung besteht typischerweise aus einer Silber-Palladium-Mischung, speziellen Glasflüssen und organischen Zusätzen und kann im Siebdruck-, Tauch- oder Spritzverfahren auf die keramischen Bauelemente aufgebracht werden. Das Einbrennen bei etwa 800° C gewährleistet eine innige Verbindung zwischen Metallisierung, Keramikkörper und internen Elektroden. Derartige Einbrennmetallisierungen eignen sich sehr gut für Reflow-Lötverfahren mit silbergepufferten Loten, aber nur bedingt für die Klebetechnik. Insbesondere ist die Festigkeit der Klebestelle abhängig von der Oberflächenstruktur und der Zusammensetzung des Glasflusses des Einbrandpräparates, wobei die Festigkeit der Klebeverbindung oft unbefriedigend ist.

Letzteres gilt auch für die neuerdings verwendeten, noch besser lötbaren dreischichtigen Anschlußmetallisierungen, bei denen auf eine Grundmetallisierung (Einbrennsilberpräparat) galvanisch eine als Diffusionssperre wirkende Nickelschicht und darüber, auf die gleiche Weise eine Lötschicht aus Zinn aufgebracht sind (vgl. K. Oitzl, "Keramische Vielschichtkondensatoren mit ablegierbeständigen Lötflächen", Siemens Components 21 (1983), Heft 5, Seite 191 bis 193).

Aus der DE-OS 37 25 455 ist auch ein keramisches elektrisches Vielschichtbauelement, insbesondere ein Kondensator, Kaltleiter oder Varistor bekanntgeworden, dessen Innenelektroden durch Einpressen einer gut benetzenden Bleilegierung in die Hohlräume poröser keramischer Zwischenschichten erzeugt werden und dessen mindestens an den Stirnflächen aufgebrachte Außenmetallisierungen, die selbst oder durch eine weitere Metallauflage lötfähig sind, aus Nickel bestehen können und galvanisch aufgebracht sein können. Abgesehen davon, daß sich die Offenlegungsschrift ausschließlich auf die Löttechnik und nicht auf die Klebetechnik bezieht, da die Anschlußmetallisierungen des bekannten Vielschichtbauelementes lötfähig sein sollen, so daß z. B. Stromzuführungsdrähte angelötet werden können, wird das Metall Nickel nur deshalb gewählt, weil es einerseits mit Blei nicht reagiert und andererseits ein Zusammenschmelzen mehrerer Keramikkörper während des Herstellungsprozesses verhindert. Die Außenmetallisierungen, die nicht porös sind, da das flüssige Blei nicht durch sie hindurch in die Hohlräume eingepreßt wird, können offenbar gleichwertig durch Bedrucken, Tauchen, galvanisch oder chemisch abgeschieden oder durch Kathodenzerstäubung (Sputtering), durch Aufdampfen oder mittels Metallspritzverfahren auf die Keramikoberfläche aufgetragen werden.

Der vorliegenden Erfindung liegt die Aufgabe zugrunde, ein keramisches elektrisches Bauelement der eingangs angegebenen Art zu schaffen, daß sich durch eine hinsichtlich Festigkeit und Haltbarkeit verbesserte Verbindung mit den üblichen Leitklebern auszeichnet, dabei aber einfach aufgebaut und einfach herstellbar ist.

Diese Aufgabe wird erfindungsgemäß dadurch gelöst, daß an den zur elektrischen Kontaktierung vorgesehenen Stellen des Bauelements jeweils als Anschlußmetallisierung eine weitgehend porenfreie Ni-Schicht galvanisch aufgetragen ist.

Die Vorteile des Gegenstandes der Erfindung werden anhand des folgenden Ausführungsbeispiels näher erläutert.

Es gibt Anwendungsfälle, bei denen es elektrisch und aus Raumersparnisgründen wünschenswert ist, beispielsweise einen Entkoppelkondensator auf einer Leiterplatte nicht neben einem IC-Chip, sondern unter ihm anzuordnen (vgl. W. Goldbrunner, "Entkoppelkondensatoren: Technologie, Auswahl, Trends", Siemens Components 27 (1989) Heft 5, Bild 6). Es werden dabei bevorzugt keramische Vielschichtkondensatoren mit etwa 100 nF verwendet. Bei der genannten Anordnung von IC und Kondensator bietet es sich an, letzteren mittels Leitkleber auf dem Subtrat zu befestigen, da er von außen nicht lötbar ist. Der Leitkleber dient in diesem Fall gleichzeitig zur mechanischen Verbindung durch Befestigung und zur elektrischen Verbindung des Bauelements mit Kontaktstellen der Leiterplatte.

Der keramische Vielschichtkondensator ist aus dünnen Schichten dielektrischen Keramikmaterials mit dazwischenliegenden Edelmetallelektroden aufgebaut. Die Edelmetallelektroden sind alternierend von Schicht zu Schicht zu gegenüberliegenden Seitenflächen des quaderförmigen Kondensatorkörpers geführt und mit einer jeweils dort anzubringenden Anschlußmetallisierung elektrisch leitend miteinander verbunden. Die Edelmetallelektroden derartiger Vielschichtkondensatoren werden vor dem Sinterprozeß mittels Siebdruck auf die dünnen Keramikschichten aufgebracht.

Überraschenderweise zeichnen sich galvanisch aufgebrachte Anschlußmetallisierungen aus Nickel durch optimale Klebeeigenschaften im Zusammenhang mit üblichen Leitklebern, wie dem Silberleitkleber, aus. Die Benetzbarkeit und die Haftung des Leitklebers ist auf den erfindungsgemäßen Anschlußmetallisierungen entscheidend besser als bei Ag/Pd Einbrennmetallisierungen. Die Nickelschicht wird dabei zweckmäßigerweise in einer Dicke von weniger als 10 μm, insbesondere in einer Dicke von 1 bis 2 μm aufgetragen. Die Nickelschicht kann aufgetragen werden, ohne daß die Keramikmasse durch die Galvanikbäder angegriffen wird. Durch Wahl der Verweilzeit in den Galvanikbädern und der Stromstärke läßt sich auf einfache Weise eine definierte Schichtstärke erzielen. Vorteilhaft ist auch, daß die galvanisch aufgetragene Nickelschicht hinreichend dicht und porenfrei ist, die Anschlußmetallisierung sich also durch eine hohe Oberflächengüte auszeichnet. Die galvanisierten Oberflächen verfügen über eine sehr hohe und lang anhaltende Beständigkeit gegenüber Umwelteinflüssen, wie sie in der Praxis beispielsweise durch die während der Lagerungszeit wirksame Atmosphäre gegeben sind.

Bisher wurde angenommen, daß Anschlußmetallisierungen aus dem oxidierenden Metall Nickel einen zu hohen Übergangswiderstand aufweisen. Die erfindungsgemäßen galvanisierten Ni-Schichten weisen jedoch überraschenderweise im Zusammenhang mit dem Leitkleber einen ähnlich guten Übergangswiderstand auf wie gelötete Ag/Pd Metallisierungen.

Die Bauelemente können mit ihren Anschlußmetallisierungen auf Platinen, geduckten Schaltungen, Substraten etc. befestigt werden, sie können beispielsweise jedoch auch durch den Leitkleber nur mit einem anderen Bauelement, z. B. einem IC, elektrisch und mechanisch verbunden und dann gemeinsam mit Kunststoff umhüllt werden. Die durch die erfindungsgemäße Anschlußmetallisierung ermöglichte Klebverbindung ist in mechanischer Hinsicht wesentlich unempfindlicher als vergleichbare Lötverbindungen. Die Durchbiegefestigkeit beispielsweise ist mehr als doppelt so groß wie bei gelöteten Bauelementen.

**Patentansprüche**

1. Keramisches elektrisches Bauelement, insbesondere keramischer Vielschichtkondensator, mit Anschlußmetallisierungen zur elektrischen Kontaktierung mittels Leitkleber
**dadurch gekennzeichnet,**
daß an den zur elektrischen Kontaktierung vorgesehenen Stellen des Bauelements jeweils als Anschlußmetallisierung eine weitgehend porenfreie Ni-Schicht galvanisch aufgetragen ist.

2. Keramisches elektrisches Bauelement nach Anspruch 1,
**dadurch gekennzeichnet,**
daß die Ni-Schicht in einer Dicke von weniger als 10 μm, insbesondere in einer Dicke von 1 - 2 μm aufgetragen wird.

3. Keramisches elektrisches Bauelement nach Anspruch 1 oder 2,
**dadurch gekennzeichnet,**
daß die Anschlußmetallisierungen zur Befestigung des Bauelements auf Substraten mittels Leitkleber vorgesehen sind.